# EUROPÄISCHE PATENTANMELDUNG

(11) **EP 2 148 364 A2**
(43) Veröffentlichungstag der Anmeldung: **27.01.2010**
(21) Anmeldenummer: 09100345.9
(22) Anmeldetag: 24.06.2009
(51) Int. Cl.: H01L 21/60, H01L 21/48

(54) **Kontaktierungsverfahren für substratbasierte Schaltungen und zugehörige Schaltungsanordnung**

(30) Priorität: 22.07.2008 DE 102008040614
(71) Anmelder: ROBERT BOSCH GMBH, 70442 Stuttgart (DE)
(72) Erfinder: Moeller, Andreas, 72768 Reutlingen (DE); Olah, Gusztav, 1048 Budapest (HU)

(57) **Zusammenfassung**

Die Erfindung betrifft Verfahren zum Vorsehen einer Verbindung zwischen einer flexiblen Folie (10) mit mindestens einer elektrisch leitenden Schicht (12) und einem starren Substrat (20) mit mindestens einer elektrisch leitenden Schicht (22). Das Verfahren umfasst die die Schritte: Vorsehen mindestens eines Substrat-Kontaktabschnitts an einer Kontaktseite des Substrats, in dem mindestens ein Bereich der leitenden Schicht des Substrats freigelegt ist, sowie Vorsehen mindestens eines Folien-Kontaktabschnitts an einer Kontaktseite der Folie, in dem mindestens ein Bereich der leitenden Schicht der Folie freigelegt ist. Ferner wird erfindungsgemäß die Kontaktseite der flexiblen Folie in Kontakt mit der Kontaktseite des starren Substrats angeordnet. Ferner wird eine dauerhafte elektromechanische Verbindung zwischen Substrat und Folie durch plastisches Verformen von Verbindungsmaterial (30) vorgesehen, das durch die Verformung sowohl mit dem Folien-Kontaktabschnitt als auch mit dem Substrat-Kontaktabschnitt in dauerhaften mechanischen Kontakt gebracht wird. Das plastische Verformen wird ausgeführt wird durch Zuführen von Ultraschallwellenenergie in das Verbindungsmaterial und Pressen der Folie auf das Substrat, wobei der Schritt des Pressens zeitgleich mit dem Schritt des Zuführens vorgesehen wird.

## Beschreibung

### Stand der Technik

Die Erfindung geht aus von Schaltungen im Kraftfahrzeugbereich.

Substratbasierte Schaltungen, bei denen elektrische Bauelemente von einem Substrat getragen werden, das diese miteinander verschaltet, sind bereits weitreichend bekannt. Hierbei wird im Allgemeinen eine Platine vorgesehen, auf der Bauelemente mittels SMT-Technik (Oberflächenmontage) oder mittels Durchstecktechnik angeordnet und über eine strukturierte Metallkaschierung miteinander verbunden sind.

Insbesondere im Bereich der Kraftfahrzeugelektronik werden spezielle Substrate als Träger verwendet, um Leistungsbauelemente sowie Steuerelektronik zu tragen. Da Leistungsbauelemente hohe Leitungsquerschnitte erfordern sowie eine ausreichende Wärmeableitung durch den Träger selbst benötigen, werden üblicherweise Keramiksubstrate verwendet, die mit einer Metallschicht bedeckt sind. Eine weitere Metallplatte kann vorgesehen sein, um die Wärme gezielt abzuleiten.

Zur Anbindung derartiger Schaltungen an Peripheriegeräte, d.h. beispielsweise Sensoren, Schalter, Aktuatoren oder andere Elemente, die im Kraftfahrzeug vorgesehen sind, können grundsätzlich Steckverbindungen, Lötverbindungen oder Bondingverbindungen verwendet werden. Insbesondere Bondingverbindungen lassen sich preiswert herstellen und werden dann eingesetzt, wenn die Verbindung zwischen Substrat und externem Bauelement dauerhaft sein kann und nicht beliebig trennbar bzw. wiederverbindbar sein muss.

Ein hierbei verwendetes Verfahren ist das Dickdrahtbonden, wobei die konstruktive Auslegung häufig durch die mechanische Stabilität des Dickdrahtes auf eine Länge von 3-18 mm begrenzt ist. Als alternative Verbindungstechnik kann Löten verwendet werden, wobei jedoch dies zu Belastungen für Bauelement und Substrat führt, da beides auf Löttemperatur erhitzt werden muß.

Die japanische Anmeldung Nr. JP 07311831 beschreibt die Verbindung eines Substrats, auf das unmittelbar ein Bauteil aufgebracht wird. Das Bauteil wird mittels einer Verbindungsmasse vorgesehen, die unter Anwendung von Ultraschall-Bauelement-Kontaktflächen direkt mit Kontaktflächen des Substrats verbindet. Die Veröffentlichung zeigt keinerlei Techniken zum Verbinden von Leiterplattensubstraten mit externen Bauelementen.

Die Druckschrift KR-2004009350 zeigt eine Halbleiterpackungstechnik, bei der Bonding-Fußpunkte aus Gold beim Bonding verformt werden, um zu verhindern, dass ein Halbleiterchip, der ein elektronisches Bauelement ausbildet, beim Packungsvorgang bricht. Es sind keinerlei Verbindungen zu externen Bauelementen vorgesehen.

Die Druckschrift US 2005/0110163 A1 zeigt ein Chip-Bonding-Verfahren mit einem Substrat, auf dem Metalle verschiedenen Härtegrads aufgebracht sind. Ein Verbindungselement ("stud bump") wird zur Verbindung zwischen einem Chip-Bauelement und einem Substrat verwendet. Das Chip-Bauelement wird Ultraschallschwingungen ausgesetzt, um die Verbindung mit dem Substrat zu verbessern. Ebenso wie die oben zitierten Veröffentlichungen zeigt dieses Dokument kein Kontaktierungsverfahren zur Anbindung von externen Komponenten an ein Substrat.

Es ist daher eine Aufgabe der Erfindung, ein Kontaktierungsverfahren und eine zugehörige Schaltungsanordnung vorzusehen, mit denen sich Verbindungen zu einem Substrat herstellen lassen.

### Offenbarung der Erfindung

Die Erfindung ermöglicht die elektrische Verbindung von Substrat und externen Anschlüssen, beispielsweise von externen Bauteilen, wobei die Verbindung kostengünstig erzeugt werden kann. Ferner wird die Verbindung hergestellt, ohne dass Substrat oder ein externes Bauteil hohen Temperaturen ausgesetzt werden muss, wie es beispielsweise beim Löten der Fall ist. Insbesondere zur Führung von hohen Strömen kann eine erfindungsgemäße Verbindung vorgesehen werden, wobei, im Gegensatz zur Bonding-Technik gemäß dem Stand der Technik, das erfindungsgemäße Verfahren durch die verwendete Fügetechnik einen geringen Kontaktwiderstand vorsieht und die Verbindung durch einen Leiter, vorzugsweise einen gemäß dem Anschlussverlauf gebogenen Leiter bzw. ein biegsamer Leiter, bsp. eine flexible Folie, vorgesehen werden kann, deren Breite im Gegensatz zu Bondingdrähten nicht beschränkt ist, und die mit einer großen Schichtdicke vorgesehen werden kann.

Ferner kann die erfindungsgemäße Verbindung mittels eines Leiters (vorzugsweise mit flachem, rechteckigem Querschnitt) vorgesehen werden, der zu einer Seite des Leiters oder zu beiden Seiten hin isoliert ist, wohingegen insbesondere das Bondingverfahren keine derartige Isolation zulässt. Neben den verbesserten Kontakteigenschaften durch einen verringerten Kontaktwiderstand (ermöglicht durch eine größere Fügefläche) erlaubt die Erfindung einer verbesserte mechanische Anbindung eines Leiters an das Substrat, wobei der Leiter zur Verbindung zu einem externen Bauteil vorgesehen werden kann.

Zudem wird durch die erfindungsgemäß eingesetzte Verbindungstechnik das Verbinden auch von unebenen Kontakten oder Kontaktebenen unterschiedlicher Höhe gegenüber dem Substrat bzw. dem jeweiligen verbindenden Bauteil ermöglicht, da die erfindungsgemäße Verformung durch Ultraschallwellenenergie, im Gegensatz zur Bonding-Technik, auch unebene Verbindungen oder Verbindungen mit unterschiedlicher Höhe der Verbindungsebene bei geringem Kontaktwiderstand (und hoher mechanischer Stabilität) herstellen kann.

Das zugrunde liegende erfinderische Konzept besteht darin, eine elektrische Verbindung zwischen einem Substrat und einem externen Kontaktpunkt (beispielsweise ein Anschluss eines peripheren Bauteils, eine elektrische Schnittstelle oder Ähnliches) vorzusehen, indem eine flexible Folie mit mindestens einer elektrisch leitenden Schicht mittels Ultraschall mit einer Kontaktstelle des Substrats verbunden wird. Hierzu sieht das Substrat beispielsweise ein Kontaktpad innerhalb eines Substrat-Kontaktabschnitts vor, auf dem eine entsprechende gegenüberliegende Kontaktstelle der flexiblen Leiterfolie bzw. des Leiterbands, vorzugsweise innerhalb eines Folien-Kontaktabschnitts, angeordnet wird. Zur Verbindung wird Verbindungsmaterial eingesetzt, das durch Verfügen mittels Ultraschall die flexible Folie mit dem Substrat verbindet.

Der gebogene bzw. flexible Leiter in Form eines Leiterbands oder einer Leiterfolie stellt so elektrischen Kontakt zwischen dem Substrat und einem peripheren Bauteil her, wobei das Bauteil eine beliebige weitere elektrische oder elektronische Komponente (ein Modul, ein einzelnes Bauteil oder Leistungsbauteil, eine Leiterplatte, ein Substrat o.ä.) sein kann, die nicht unmittelbar in Kontakt mit dem Substrat ist oder an einer anderen Stelle des Substrats angeordnet ist. Peripher bedeutet in diesem Zusammenhang, dass die zu kontaktierende Komponente nicht direkt an dem Substrat-Kontaktabschnitt oder nicht direkt an dem Substrat angeordnet ist. Mit der Leiterfolie lassen sich so Distanzen überbrücken, die durch die Ausgestaltung der Schaltung bedingt sind, welche die externe Komponente und das Substrat umfasst. Der Leiter ist vorzugsweise flach, d.h. als Band oder Folie ausgestaltet und hat vorzugsweise eine flachen rechteckigen Querschnitt mit einem Seitenverhältnis a/b ≥ 3, ≥ 5, ≥ 10, ≥ 20, ≥ 50, ≥ 100, ≥ 200 oder ≥ 500.

Die Ultraschallwellenenergie kann direkt in das Verbindungsmaterial eingeleitet werden, beispielsweise wenn der Folien-Kontaktabschnitt ein Durchgangsloch umfasst, welches gegenüber dem Substrat-Kontaktabschnitt angeordnet wird und, auf der gegenüber dem Substrat abgewandten Seite, das Verbindungsmaterial angeordnet wird. Das Verbindungsmaterial kann beispielsweise ein Dickdraht sein. Ein Ultraschallsender, vorzugsweise ein Kopf eines Ultraschallwerkzeugs, wird in diesem Fall in Kontakt mit dem Verbindungsmaterial gebracht, unter dem sich das Durchgangsloch sowie die flexible Folie befindet. Das unter der Folie vorgesehene Substrat bzw. die zwischen einer Isolierschicht des Substrats und der flexiblen Folie vorgesehen leitende Schicht des Substrats kontaktiert die Seite der elektrisch leitenden Schicht der flexiblen Folie, die dem Substrat zugewandt ist, so dass der Werkzeugkopf durch Druck auf das Verbindungsmaterial auch die elektrisch leitende Schicht der flexiblen Folie auf die elektrisch leitende Schicht des Substrats drückt. Durch Anwenden der Ultraschallwellenenergie wird das Verbindungsmaterial verformt und gemäß dem zum Substrat hin gerichteten Druck wird das Verbindungsmaterial plastisch in seiner Form dauerhaft verändert, tritt durch das Durchgangsloch hindurch und verbindet sich durch Fügen mit der elektrisch leitenden Schicht des Substrats.

Die elektrisch leitende Schicht des Substrats ist vorzugsweise auf einer Oberfläche bzw. auf einer Seite des Substrats vorgesehen, oder kann innerhalb des Substrats vorgesehen sein, wobei in diesem Fall darüber liegende Schichten, beispielsweise Isolationsschichten, entfernt sind. In gleicher Weise kann die flexible Folie neben der mindestens einen elektrisch leitenden Schicht eine oder mehrere Isolationsschichten umfassen, die in gleicher Weise an dem Folien-Kontaktabschnitt eine Ausnehmung aufweisen. Die Ausnehmung kann nur auf der Seite des Folien-Kontaktabschnitts sein, der beim Anordnen mit dem Substrat dem Substrat zugewandt ist, oder kann zu beiden Seiten der flexiblen Folie vorgesehen sein.

Das Substrat sowie die flexible Folie werden somit vor dem Zusammenfügen übereinander gelegt und zueinander derart angeordnet, dass ein, mehrere oder alle Substrat-Kontaktabschnitte über den zugeordneten Folien-Kontaktabschnitten liegen. Die flexible Folie weist somit eine Kontaktseite auf, die dem Substrat zugewandt ist, und das Substrat weist ebenso eine Kontaktseite auf, die der Folie zugewandt ist. Die elektrische Verbindung ist gleichzeitig eine stabile mechanische Verbindung, da das Verbindungsmaterial zumindest mit der leitenden Schicht des Substrats einen dauerhaften mechanischen Kontakt in Form einer Fügeverbindung eingeht. Die elektrische Verbindung wird somit durch das Verbindungsmaterial vorgesehen, welches gleichzeitig mit der Folie und dem Substrat verbunden ist, sowie durch den direkten Kontakt zwischen Folie und Substrat selbst, da diese mittels Verbindungsmaterial an den jeweiligen Kontaktabschnitten aufeinander gepresst werden.

Insbesondere durch das Verbindungsmaterial, welches durch Ultraschall bzw. Mikroschweißen mittels Ultraschall mit der leitenden Schicht des Substrats verbunden wird, wird ein elektrischer Kontakt mit guten elektrischen und auch verbesserte mechanischen Eigenschaften vorgesehen. Insbesondere wird hierdurch ein geringer Kontaktwiderstand erzielt.

Die leitende Schicht des Substrats (sowie die leitende Schicht der Folie) kann einen oder mehrere Kontaktabschnitte umfassen, kann strukturiert sein und Kontaktpads bzw. Kotankflächen ausformen und kann zur mechanischen Stabilität mindestens eine weitere Trägerschicht umfassen, die selbst elektrisch isolierend ist oder von der jeweiligen leitenden Schicht elektrisch isoliert ist.

Während bei der oben beschriebenen Ausführungsform das Verbindungsmaterial durch das Durchgangsloch von einer Seite der flexiblen Folie auf die andere Seite der flexiblen Folie durch Ultraschallverformung wandert, d.h. auf die Kontaktseite der Folie, kann in einer weiteren Ausführungsform der Erfindung das Verbindungsmaterial bereits zwischen flexibler Folie und Substrat, d.h. zwischen den jeweiligen Kontaktseiten, vorgesehen sein, bevor die Ultraschallenergie zum plastischen Verformen eingesetzt wird. In diesem Fall umfasst mindestens einer der Substrat-Kontaktabschnitte bzw. eine entsprechend dort angeordnete Kontaktstelle in Form eines Kontaktpads bereits einen Verbindungskörper bzw. ein Verbindungselement aus Verbindungsmaterial, das auf der Kontaktseite und somit auf der leitenden Schicht des Substrats angeordnet ist. In Kombination hierzu oder stattdessen kann vor dem plastischen Verformen ein entsprechender Verbindungsmaterial-Kontaktkörper auf der elektrisch leitenden Schicht der flexiblen Folie vorgesehen sein, insbesondere in mindestens einem der Folien-Kontaktabschnitte. Dies kann erreicht werden, indem Verbindungsmaterial an die jeweiligen Stellen des Substrat-Kontaktabschnitts oder Folien-Kontaktabschnitts aufgebracht wird, indem kleine Kontaktkörper ("*balls*") aus verformbarem, weichem und leitendem Material dort zunächst angeordnet werden und mittels Pressen mit dem Substrat bzw. mit der Folie haftend verbunden werden. Die Verbindungskörper können in Form von *stud bumps* an den Kontaktabschnitt oder an die Kontaktabschnitte angebracht werden.

Die Kontaktkörper, welche das Verbindungsmaterial vorsehen, können aus Gold vorgesehen sein, oder aus einem Stoff, der Gold umfasst. Insbesondere können Goldlegierungen eingesetzt werden. Als Stoffe für das Verbindungsmaterial sind prinzipiell alle festen leitenden Stoffe geeignet, die sich plastisch verformen lassen, vorzugsweise Metalle oder Legierungen bzw. Compounds mit Metallen oder Legierungen, insbesondere Metalle oder Legierungen, die sich leicht verformen lassen, wie Gold, Aluminium, Kupfer usw.

Das Verbindungsmaterial kann aufgebracht werden, indem dieses auf dem Substrat abgeschieden wird (vorzugsweise wenn das Verbindungsmaterial vor dem Verformungsvorgang zwischen den Kontaktseiten vorgesehen ist) oder kann in Form von Bondingdraht, vorzugsweise Dickdraht, vorgesehen sein, wenn das Verbindungsmaterial von der Seite der flexiblen Folie herangeführt wird, die der Kontaktseite der Folie gegenüberliegt. Das Verbindungsmaterial kann in Form von Kugeln aufgebracht werden oder kann mittels Galvanisieren aufgebracht werden.

Als starres Substrat kann Keramiksubstrat verwendet werden, das auf der Kontaktseite des Substrats eine Metallschicht oder Metallkaschierung aufweist, beispielsweise aus Kupfer oder aus Aluminium. Die der Kontaktseite des Substrats entgegengesetzte Seite kann zur Wärmeableitung ein Metallblech aufweisen, beispielsweise aus Aluminium. Als Substrat können auch Kunststoff bzw. Epoxy-basierte Leiterplatten verwendet werden, jedoch werden vorzugsweise für Leistungsanwendungen keramikbasierte Substrate wie LTCC-, HTCC- oder DBC- oder AMB-Substrate verwendet, beispielsweise aus Al₂O₃, Aln oder BeO. Sowohl für die flexible Folie als auch für das Substrat können neben Kupfer und Aluminium auch Silber, AgPd oder beschichtete Metallschichten verwendet werden. Zur Realisierung der flexiblen Folie werden vorzugsweise flexible Leiterplatten verwendet, beispielsweise auf Kunststoffschichten, die Metallschichten tragen, beispielsweise Polyimid oder Polyester mit Kupferkaschierung.

Als flexible Folie können flexible Leiterplatten verwendet werden, die ohne funktionelle Schäden gebogen werden können, beispielsweise mit einem Kurvenradius des Querschnittverlaufs von weniger als 50 cm, weniger als 20 cm, weniger als 10 cm, weniger als 5 cm oder weniger als 2 cm. Da das Verfahren insbesondere für fest montierte Substrate bzw. externe Baugruppen vorgesehen ist, können auch als flexible Folie Metallschichten verwendet werden, die sich einige wenige Male wiegen lassen, ohne strukturellen Schaden zu nehmen. Beispielsweise könnte somit als flexible Folie ein Blech aus Kupfer, Aluminium, Stahl oder Silber verwendet werden, das eine Dicke von weniger als 3 mm, 2 mm, 1 mm, 0,5 mm oder 0,2 mm aufweist und gegebenenfalls auf einer oder auf beiden Seiten eine Isolationsschicht aufweist. Die Isolationsschicht ist vorzugsweise ebenso flexibel und löst sich bei einer Biegung mit einem wie oben beschriebenen Kurvenradius nicht ab. Eine derartige Isolationsschicht bzw. elektrisch isolierende Schicht kann auch mittels Lack oder dünnem Kunststoffüberzug vorgesehen werden.

Grundsätzlich ist die Verbindung, welche das Verbindungsmaterial zwischen Substrat und flexibler Folie vorsieht, ein dauerhafter mechanischer Kontakt, der nur gelöst werden kann, indem die elektrisch leitende Schicht der flexiblen Folie, des Substrats oder beider Komponenten zumindest teilweise zerstört wird. Das erfindungsgemäße Verfahren zum Vorsehen einer Verbindung und die damit verknüpfte Schaltungsanordnung ist dazu vorgesehen, einen elektromechanischen Kontakt einmalig herzustellen, der während der üblichen Anwendung im Weiteren nicht gelöst wird.

Die erfindungsgemäß vorgesehene Verbindung eignet sich zur Verbindung von Substraten, die als Leistungssubstrat realisiert sind, und die mindestens ein Leistungsbauelement tragen. Die erfindungsgemäß vorgesehene Verbindung wird vorzugsweise im Kraftfahrzeugbereich eingesetzt, d.h. zur Verbindung von Elektronik-Leistungsbauteilen in Baugruppen, die Funktionen in einem Kraftfahrzeug vorsehen, welche mit hohen Strömen (größer als 1 A), verknüpft sind. Beispiele hierfür sind Aktuatoren, Pumpen, Batterieladesysteme im Antrieb oder im Bremskreis. Die flexible Folie dient hierzu zur Leitung von hohen Strömen (größer als 1 A, größer als 5 A, größer als 10 A oder größer als 20 A) und somit zum generellen Anschluss von Elektro-Komponenten wie die vorgehend beschriebenen Baugruppen. Auf die Verbindungsseite der Baugruppe kann die flexible Folie mittels der erfindungsgemäßen elektromechanischen Verbindung angeschlossen werden, oder mittels Steck-, Schraubsystemen oder weiteren elektromechanischen Verbindungstechniken, die für hohe Leistungen ausgelegt sind.

In der erfindungsgemäßen Schaltungsanordnung wird das starre Substrat mit der flexiblen Folie mittels des Verbindungsmaterials verbunden, welches (nachdem es plastisch verformt wurde) die Konturen bzw. die äußere Form des Substrat-Kontaktabschnitts sowie des Folien-Kontaktabschnitts vorsieht. Zwischen Verbindungsmaterial und elektrisch leitenden Schichten besteht eine kraftschlüssige, formschlüssige und/oder stoffschlüssige Verbindung. Durch entsprechende Ausbildung der Kontaktabschnitte kann ein Ineinandergreifen von Verbindungsmaterial in den jeweiligen Kontaktabschnitt erreicht werden, wodurch sich eine höhere Stabilität ergibt.

### Kurze Beschreibung der Zeichnungen

Ausführungsbeispiele der Erfindung sind in den Zeichnungen dargestellt und in der nachfolgenden Beschreibung näher erläutert.

Es zeigen
- Figuren 1a und 1b: eine erste Ausführungsform der erfindungsgemäßen Verbindung; und
- Figuren 2a, 2b: eine zweite Ausführungsform der erfindungsgemäßen Verbindung.

### Ausführungsformen der Erfindung

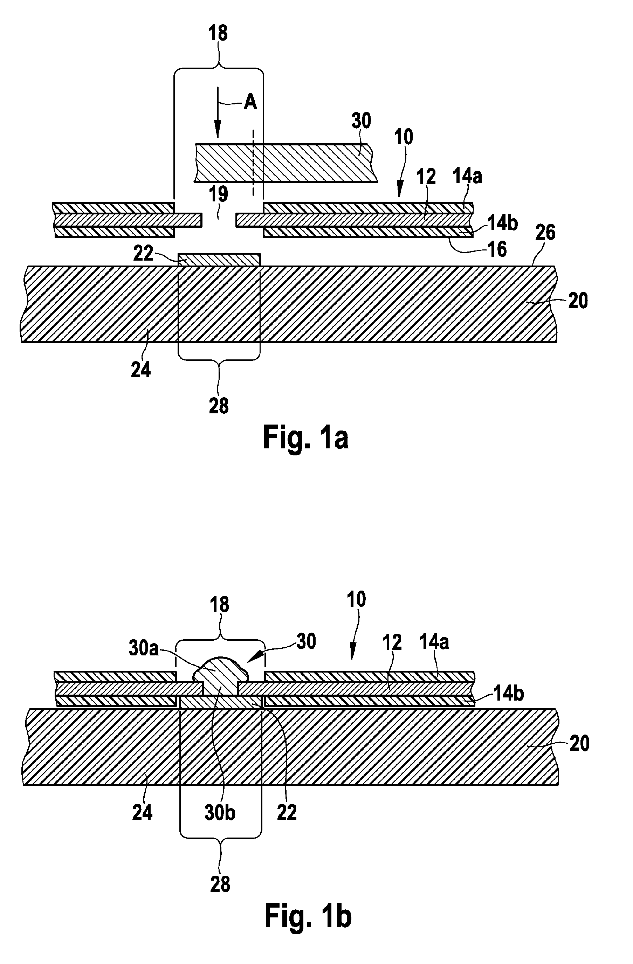

In der Figur 1 ist eine erste Ausführungsform einer erfindungsgemäßen Schaltungsanordnung dargestellt, die mit dem erfindungsgemäßen Verfahren hergestellt wurde. Zunächst wird eine flexible Folie 10 mit einer elektrisch leitenden Schicht 12 über einem starren Substrat 20 angeordnet. Die Unterseite der flexiblen Folie bildet die Kontaktseite 16 der flexiblen Folie 10, welche der Kontaktseite 26 des starren Substrats 20 gegenüberliegt. Das Substrat 20 umfasst auf der Kontaktseite 26 eine leitende Schicht 22 (welche Leiterbahnen bzw. Kontaktflächen vorsehen kann), die auf einer isolierenden Trägerschicht 24 aufgebracht ist. Die leitende Schicht 22 ist beispielsweise als Leiterbahn oder Kontaktpad ausgeführt und durch bekannte Verfahren strukturiert, beispielsweise photolitographische Ätzverfahren, Fräsen oder Laserablation. Das dargestellte Kontaktpad, das als strukturierte leitende Schicht 22 des Substrats 20 ausgeführt ist, ist in einem Substrat-Kontaktabschnitt 28 angeordnet, dem ein Folien-Kontaktabschnitt 18 entspricht. Im Substrat-Kontaktabschnitt sowie im Folien-Kontaktabschnitt sind die jeweiligen elektrisch leitenden Schichten exponiert und sind zur jeweils gegenüberliegenden elektrisch leitenden Schicht hin nicht bedeckt.

Zur Herstellung der dauerhaften elektromechanischen Verbindung wird ein Verbindungsmaterial 30 vorgesehen, welches über dem Folien-Kontaktabschnitt gegenüberliegend zum Substrat angeordnet wird. Das Verbindungsmaterial 30, welches als Draht, Folie oder Blech vorgesehen sein kann, wird senkrecht zur Oberfläche der flexiblen Folie und senkrecht zur Oberfläche des Substrats auf das Substrat gepresst. Durch die Anordnung der flexiblen Folie 10 zwischen Verbindungsmaterial 30 und Substrat 20 wird der Folien-Kontaktabschnitt auf den Substrat-Kontaktabschnitt gedrückt. Ein Ultraschall-Werkzeugkopf (nicht dargestellt) wird verwendet, um das Verbindungsmaterial gemäß der Richtung des Pfeils A auf ein Durchgangsloch 19 der flexiblen Folie 10 zu drücken, wobei die Ultraschallenergie einen Teil des Verbindungsmaterials 30 durch das Durchgangsloch 19 hindurch mit der leitenden Folie 28 des Substrats verbindet.

Um den Kontakt zwischen Verbindungsmaterial und flexibler Folie 10 zu vereinfachen, weist die isolierende Schicht 14a an dem Folien-Kontaktabschnitt 18 eine Aussparung auf, die sich über den gesamten Folien-Kontaktabschnitt erstreckt. Um den Kontakt zwischen leitender Schicht 12 der Folie 10 und der leitenden Schicht 22 des Substrats 20 zu vereinfachen, weist in gleicher Weise die Isolationsschicht 14b, die dem Substrat 20 zugewandt ist, eine Aussparung auf, die sich ebenso über den gesamten Folien-Kontaktabschnitt erstreckt. Zumindest die Aussparung in der zum Substrat gewandten Isolierschicht erstreckt sich vorzugsweise mindestens über die Fläche, die die leitende Schicht 28 des Substrats 20 einnimmt. Für die Zulieferung des Verbindungsmaterials 30 wird ein Draht verwendet, von dem nur ein Abschnitt (Trennungslinie gestrichelt dargestellt) zum Vorsehen der dauerhaften elektromechanischen Verbindung verwendet wird.

Die Figur 1b zeigt die Struktur von Figur 1a nach dem Ausführen des erfindungsgemäßen Verfahrens. Über dem Substrat 20 ist in einem Substrat-Kontaktabschnitt 28 eine leitende Schicht 22 des Substrats vorgesehen, wobei sich direkt über dem Substrat-Kontaktabschnitt 28 der Folien-Kontaktabschnitt 18 befindet. Der Substrat-Kontaktabschnitt kann in den Folien-Kontaktabschnitt passen oder mit zusätzlichem Rand eingepasst werden. Die leitende Schicht 12 der flexiblen Folie 10, und die leitende Schicht 22 des Substrats 20 werden durch das Verbindungsmaterial 30 verbunden, das im Wesentlichen die Form einer eingefügten Niete aufweist. Das Verbindungsmaterial bildet einen Nietenkopf 30a aus, der über einen Steg 30b mittels einer stoffschlüssigen Verbindung mit der leitenden Schicht 22 des Substrats 20 verbunden ist.

Vorzugsweise ist die dem Substrat zugewandte Isolationsschicht 14b der flexiblen Folie mit einer geringeren Dicke ausgestaltet als die Schichtdicke der leitenden Schicht 22 des Substrats 20. Auf diese Weise kann die flexible Folie im Kontaktbereich planparallel zum Substrat verlaufen. Andernfalls wird vorzugsweise eine Aussparung in der Isolationsschicht 14b vorgesehen, die um ein Mindestmaß größer als die Fläche der leitenden Schicht 22 ist, so dass sich die leitende Schicht 12 der flexiblen Folie 10 im Folien-Kontaktabschnitt ausreichend biegen kann, ohne dass eine Maximalspannung innerhalb der flexiblen Folie überschritten wird. In diesem Fall kann die Isolationsschicht 14a, die dem Substrat abgewandt ist, eine kleinere Aussparung als die Isolationsschicht 14b aufweisen, oder eine Aussparung, die mindestens genauso groß wie die Aussparung in der Isolationsschicht 14b ist.

Die Verbindung zwischen der Isolationsschicht 24 des Substrats 20 und der leitenden Schicht 28 des Substrats 20 kann vorgesehen werden durch eine Klebeverbindung oder durch Sintern. Sowohl die flexible Folie als auch das Substrat können mehrlagig ausgeführt werden, d.h. mit mehreren leitenden Schichten, die durch jeweilige Isolationsschichten getrennt sind. Ferner kann das Substrat auf der Seite, die der Kontaktseite des Substrats entgegengesetzt ist, eine Metall-Basisplatte umfassen, die von einem Blech vorgesehen wird, das Wärme ableitet, die in das Substrat eingebracht wurde. Eine derartige Wärme kann beispielsweise durch Leistungsbauteile in das Substrat eingebracht werden, die auf dem Substrat vorgesehen sind. Das Substrat (und gegebenenfalls auch die flexible Folie) tragen vorzugsweise Leistungsbauteile, die als SMD-Bauteile ausgebildet sind. Die Figuren sind jedoch zur besseren Übersicht ohne Bauelemente dargestellt.

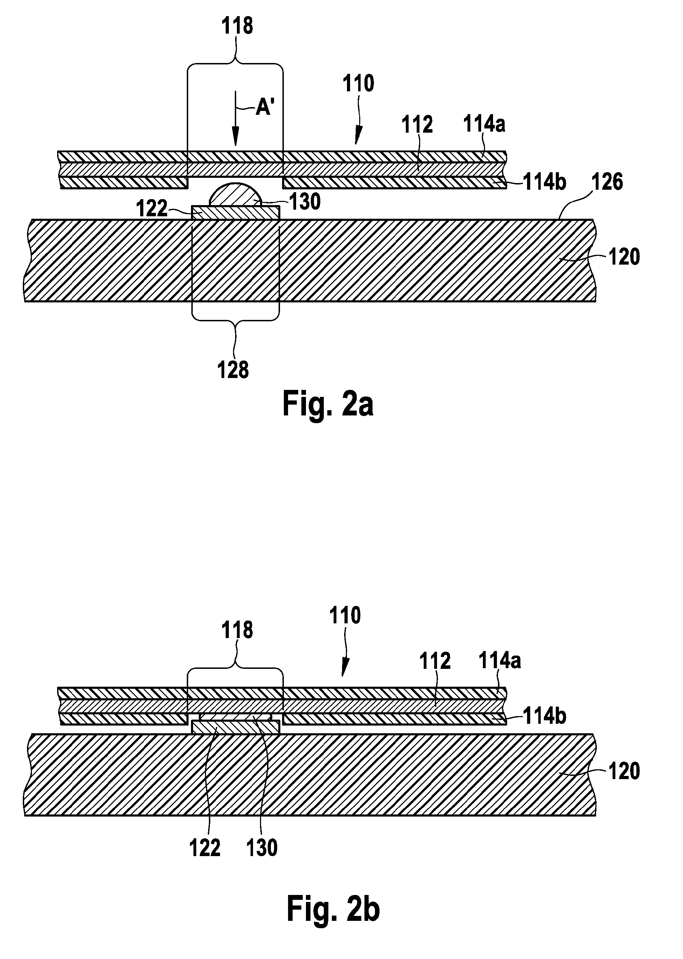

In der Figur 2b ist eine zweite Ausführungsform der erfindungsgemäßen Erfindung dargestellt, wobei die Figur 2a die Anordnung der Komponenten vor dem plastischen Verformen des Verbindungsmaterials darstellt. Das Substrat 120 ist auf der Kontaktseite 126 mit einer leitenden Schicht 122 ausgestattet, die in einem Substrat-Kontaktabschnitt 128 angeordnet ist. Die obenstehenden Merkmale der zweiten Ausführungsform entsprechen somit den Merkmalen der ersten Ausführungsform, die anhand der Figuren 1a und 1b beschrieben wurde. Wie auch in der ersten Ausführung umfasst die zweite Ausführung eine flexible Folie 110, welche eine leitende Schicht 112 umfasst, welche zu beiden Seiten mit einer Isolierschicht 114a, 114b abgedeckt ist.

Die Isolierschicht 114b weist eine Aussparung auf, die sich über den gesamten Folien-Kontaktabschnitt 118 erstreckt, der hinsichtlich der Isolationsschicht 114b, die dem Substrat zugewandt ist, der in Figur 1a,b dargestellten Ausführung entspricht. Im Gegensatz zur ersten Ausführung ist das Verbindungsmaterial 130 bereits vor dem plastischen Verformen direkt auf der leitenden Schicht 122 des Substrats 120 angeordnet. Das Verbindungsmaterial erhebt sich somit in einer Richtung, die vom Substrat weg zeigt, wobei diese Erhebung erfindungsgemäß in den Folien-Kontaktabschnitt 118 eingepasst wird. Der Folien-Kontaktabschnitt und die Anordnung des Verbindungsmaterials 130 sind somit zueinander ausgerichtet. Daraufhin wird in Richtung des Pfeils A' ein Ultraschall-Werkzeugkopf (nicht dargestellt) auf die flexible Folie aufgelegt, so dass sich die leitende Schicht 112 auf das Verbindungsmaterial 130 absenkt.

Das Ergebnis der dadurch erreichten plastischen Verformung ist in der Figur 2b dargestellt, in der das Substrat 120 die leitende Schicht 122 trägt, über der das verformte Verbindungsmaterial 130 angeordnet ist. Es ist aus der Figur 2b zu erkennen, dass sich das Verbindungsmaterial an die Oberfläche der leitenden Schicht der flexiblen Folie an der Kontaktseite der Folie angepasst hat und mit dieser eine mechanische Verbindung bildet. Ebenso wurde die mechanische Verbindung zwischen Verbindungsmaterial 130 und der leitenden Schicht 122 des Substrats 120 erweitert bzw. verstärkt. Die Ultraschallwellenenergie kann durch die Isolationsschicht 114a, welche auf der Substrat abgewandten Seite der Folie angeordnet ist, hindurch übertragen werden. Es ist somit nicht unbedingt notwendig, im Folien-Kontaktabschnitt 118 eine Aussparung in einer Isolationsschicht 114a vorzusehen, die nicht zwischen der leitenden Schicht 112 der flexiblen Folie 110 und der leitenden Schicht 122 des Substrats 120 liegt.

Je nach Länge des Verbindungsmaterials erstreckt sich das Verbindungsmaterial nach Anwendung des erfindungsgemäßen Verfahrens über eine Fläche, die kleiner als die Fläche der leitenden Schicht 122 ist, und in dieser vollständig aufgenommen ist, oder über eine Fläche, die der Oberfläche der leitenden Schicht 122 entspricht, oder über eine Fläche, die größer als die Fläche der leitenden Schicht ist, und diese vollständig umfasst. Mit anderen Worten kann das Verbindungsmaterial 130 über die leitende Schicht 122 hinaustreten, so dass vorzugsweise in diesem Fall der Folien-Kontaktabschnitt größer als die Oberfläche der leitenden Schicht 122 des Substrats 120 ist, um das übergetretene Verbindungsmaterial aufzunehmen, ohne in der flexiblen Folie eine Spannung zu erzeugen. Die Aussparung in der Isolierschicht 114b oder in allen Isolierschichten, die zwischen der leitenden Schicht der Folie und der leitenden Schicht des Substrats 120 liegen, kann mit einer Endkante (nicht dargestellt) der flexiblen Folie abschließen.

## Patentansprüche

1. Verfahren zum Vorsehen einer Verbindung zwischen einer flexiblen Folie mit mindestens einer elektrisch leitenden Schicht und einem starren Substrat mit mindestens einer elektrisch leitenden Schicht, wobei das Verfahren die Schritte umfasst:
Vorsehen mindestens eines Substrat-Kontaktabschnitts an einer Kontaktseite des Substrats, in dem mindestens ein Bereich der leitenden Schicht des Substrats freigelegt ist;
Vorsehen mindestens eines Folien-Kontaktabschnitts an einer Kontaktseite der Folie, in dem mindestens ein Bereich der leitenden Schicht der Folie freigelegt ist;
Anordnen der Kontaktseite der flexiblen Folie in Kontakt mit der Kontaktseite des starren Substrats,
Herstellen einer dauerhaften elektromechanischen Verbindung zwischen Substrat und Folie durch plastisches Verformen von Verbindungsmaterial, das durch die Verformung sowohl mit dem Folien-Kontaktabschnitt als auch mit dem Substrat-Kontaktabschnitt in dauerhaften mechanischen Kontakt gebracht wird, wobei das plastische Verformen ausgeführt wird durch Zuführen von Ultraschallwellenenergie in das Verbindungsmaterial und Pressen der Folie auf das Substrat, wobei der Schritt des Pressens zeitgleich mit dem Schritt des Zuführens vorgesehen wird.

2. Verfahren nach Anspruch 1, das ferner umfasst: Vorsehen eines Durchgangslochs in mindestens einem der Folien-Kontaktabschnitte durch die Folie hindurch, Anordnen des Verbindungsmaterials vor dem Schritt des plastischen Verformens an dem Durchgangsloch auf einer Seite der Folie, die der Kontaktseite der Folie gegenüberliegt, wobei die Ultraschallwellenenergie in das Verbindungsmaterial zugeführt wird durch Aufpressen eines Ultraschallsenders direkt auf das Verbindungsmaterial, und durch das Aufpressen des Ultraschallsenders auf das Verbindungsmaterial ferner die Folie auf das Substrat gepresst wird.

3. Verfahren nach Anspruch 1 oder 2, das ferner umfasst: Anordnen von Verbindungsmaterial vor dem Schritt des plastischen Verformens zwischen die Kontaktseite der Folie und die Kontaktseite des Substrats in Kontakt mit dem Folien-Kontaktabschnitt und dem Substrat-Kontaktabschnitt; wobei die Ultraschallwellenenergie in das Verbindungsmaterial zugeführt wird durch Aufpressen eines Ultraschallsenders direkt auf einer Seite der Folie, die der Kontaktseite der Folie gegenüberliegt, an der das Verbindungsmaterial angeordnet ist, wobei die Ultraschallwellenenergie durch die Folie hindurch an das Verbindungsmaterial übertragen wird; und direkt auf das Verbindungsmaterial, und durch das Aufpressen des Ultraschallsenders auf die Folie auf das Substrat gepresst wird.

4. Verfahren nach einem der vorangehenden Ansprüche, das ferner umfasst: Versehen des Substrats, der Folie oder beides mit mindestens einer elektrisch isolierenden Isolationsschicht, die sich zwischen der mindestens einen leitenden Schicht des Substrats und der mindestens einen leitenden Schicht der Folie angeordnet ist, wobei das Verfahren ferner umfasst: Erzeugen einer Aussparung in der mindestens einen Isolationsschicht an dem Substrat-Kontaktabschnitt und dem Folien-Kontaktabschnitt.

5. Verfahren nach einem der vorangehenden Ansprüche, wobei das Substrat mit einer elektrisch isolierenden Substrat-Trägerschicht ausgebildet ist, auf der die mindestens eine elektrisch leitende Schicht des Substrats aufgebracht ist, und die Folie mit einer elektrisch isolierenden Folien-Trägerschicht ausgebildet ist, auf der die mindestens eine elektrisch leitende Schicht der Folie aufgebracht ist.

6. Verfahren nach einem der vorangehenden Ansprüche, wobei das Herstellen einer dauerhaften elektromechanischen Verbindung umfasst: Heranführen eines Drahts aus Verbindungsmaterial an den Folien-Kontaktabschnitt oder an den Substrat-Kontaktabschnitt, bevor das Verbindungsmaterial plastisch verformt wird, oder Aufbringen von mindestens einem Kontaktelement aus Verbindungsmaterial auf den Substrat-Kontaktabschnitt, das sich von der Kontaktseite des Substrats erhebt, oder Aufbringen von mindestens einem Kontaktelement aus Verbindungsmaterial auf den Folien-Kontaktabschnitt, das sich von der Kontaktseite der Folie erhebt.

7. Schaltungsanordnung mit einem starren Substrat, das mindestens eine elektrisch leitende Schicht umfasst, und einer flexiblen Folie, die mindestens eine elektrisch leitende Schicht umfasst, wobei das Substrat mindestens einen Substrat-Kontaktabschnitt an einer Kontaktseite des Substrats umfasst, in dem mindestens ein Bereich der leitenden Schicht des Substrats freigelegt ist; und die Folie mindestens einen Folien-Kontaktabschnitt an einer Kontaktseite des Substrats umfasst, in dem mindestens ein Bereich der leitenden Schicht des Substrats freigelegt ist; und die Schaltungsanordnung eine dauerhafte elektromechanischen Verbindung zwischen Substrat und Folie aus Verbindungsmaterial umfasst, das sowohl mit dem Folien-Kontaktabschnitt als auch mit dem Substrat-Kontaktabschnitt in elektromechanischem Kontakt steht, wobei die elektromechanische Verbindung durch Pressen und Zuführen von Ultraschallwellenenergie plastisch verformtes Verbindungsmaterial umfasst, dessen äußere Form teilweise dem Verlauf des Substrat-Kontaktabschnitts sowie teilweise dem Verlauf des Folien-Kontaktabschnitts entspricht.

8. Schaltungsanordnung nach Anspruch 7, wobei die flexiblen Folie eine elektrische Schnittstelle außerhalb des Folien-Kontaktabschnitts aufweist, die über die Folie mit der elektromechanischen Verbindung und mit der elektrisch leitenden Schicht des Substrats elektrisch leitend verbunden ist, und die elektrische Schnittstelle einen Peripherie-Kontakt aufweist, der zum Anschluss eines elektrischen Bauteils, eines elektronischen Bauteils, eines elektrischen Verbindungselements, eines Schaltkreises oder eines Substrats eingerichtet ist.

9. Schaltungsanordnung nach Anspruch 7 oder 8, wobei das Substrat einen Keramikträger umfasst, der im Wesentlichen starr ist, das Verbindungsmaterial Au, Ag, Al, Zn oder eine Mischung hiervon umfasst, und die Folie eine flexible, isolierende Kunststoffschicht umfasst.
